# EUROPEAN PATENT APPLICATION

(11) **EP 1 795 469 A1**
(43) Date of publication of application: **13.06.2007**
(21) Application number: 06125472.8
(22) Date of filing: 06.12.2006
(51) Int. Cl.: B65H 16/04, B65H 75/24

(54) **Tape holding device**

(30) Priority: 06.12.2005 JP 2005351946
(71) Applicant: TOKYO SEIMITSU CO., LTD., Mitaka-shi Tokyo (JP)
(72) Inventor: Akahori, Hajime c/o Tokyo Seimitsu Co., Ltd., Tokyo (JP)
(74) Representative: Skone James, Robert Edmund

(57) **Abstract**

A tape holding device (1) for holding, on a wall, a roll of tape having a cylindrical inner surface, including: a base rod member (10) capable of being supported on the wall in a cantilever state, the base rod member having a first mount end capable of being rotatably mounted to the wall, a second free end opposite to the first end, and an outer surface between the first end and the second end; and a clamping rod member (20) connected coaxially to the second end of the base rod member; the clamping rod member including: a clamp element (24) provided movably in a radial direction of the base rod member (10) between an initial position where the clamp element does not project from the outer surface of the base rod member and a clamp position where the clamp element projects from the outer surface, the clamp element (24) being capable of abutting the inner surface of the roll of tape at the clamp position to apply a pressure to the inner surface; and a pressing unit provided movably in an axial direction of the base rod member between a non-operative position where the pressing unit does not press the clamp element and an operative position where the pressing unit presses the clamp element to move the clamp element from the initial position to the clamp position and to make the clamp element generate the pressure.

## Description

The present invention relates to a tape holding device for holding a roll of tape to be applied to a surface of a product, for example, a wafer, in order to protect the surface.

A tape holding device for holding a roll of tape on a cantilever-type base rod is generally known and is disclosed in, for example, Japanese Unexamined Patent Publication (Kokai) No. 10-35612 (JP-A-10-35612). As shown in Fig. 4, a tape holding device 100 has a base rod 101 projecting horizontally via a boss 103 from a breast portion 105b of a vertically movable frame 105. A roll of tape 104 having a protective tape 104b wound in a roll on a cylindrical core member 104a is attached to the base rod, and the roll of tape 104 is adapted to be held between a retaining ring 102 mounted to a free end of the base rod 102 and the boss 103 so as not to be detached.

In this example of prior art, however, there is no means for absorbing the gap between the roll of tape 104 and the base rod 101, and there is a problem that, depending on the variation of the inner diameter of the roll of tape 104, the gap between the roll of tape 104 and the base rod 101 may become excessively large and may make instability of the roll of tape 104 unstable.

In another example of tape holding device that overcomes above-mentioned problem, a screw, provided at the end of the base rod, is tightened so as to move the core provided on the base rod in radial outward direction and to exert internal pressure to the inner surface of the roll of tape to thereby hold the roll of tape stably on the base rod.

In the tape holding device wherein a screw is tightened to move the core so as to hold the roll of tape, there is a problem that, each time a roll of tape is replaced to the base rod, the screw has to be removed and the removed screw has to be replaced and tightened again so that attaching/detaching of the roll of tape takes time and the device has thus poor workability.

Further, there is another problem that the extent of tightening of the screw varies with workers and screw threads may be damaged by excessive tightening. Although it is also possible to use pneumatic means to move the core of the base rod in radial outward direction, this complicates the tape holding device and leads to an increase in cost.

In view of above-described problem, it is an object of the present invention to provide a tape holding device that permits a roll of tape to be attached to the base rod easily with one action.

In order to attain above object, in accordance with the present invention, there is provided a tape holding device for holding, on a wall, a roll of tape having a cylindrical inner surface, comprising: a base rod member capable of being supported on the wall in a cantilever state, the base rod member including a first mount end capable of being rotatably mounted to the wall, a second free end opposite to the first end, and an outer surface between the first end and the second end; and a clamping rod member connected coaxially to the second end of the base rod member; the clamping rod member comprising: a clamp element provided movably in a radial direction of the base rod member between an initial position where the clamp element does not project from the outer surface of the base rod member and a clamp position where the clamp element projects from the outer surface, the clamp element being capable of abutting the inner surface of the roll of tape at the clamp position to apply a pressure to the inner surface; and a pressing unit provided movably in an axial direction of the base rod member between a non-operative position where the pressing unit does not press the clamp element and an operative position where the pressing unit presses the clamp element to move the clamp element from the initial position to the clamp position and to make the clamp element generate the pressure.

In the tape holding device described above, the force that pushes the pressing unit toward the basal end of the base rod is converted to the force pressing the clamp element in radial outward direction, and the clamp element is thereby moved in radial outward direction of the base rod so that the outer surface of the clamp element exerts pressure to the inner surface of the roll of tape so as to fix the roll of tape to the base rod. In this manner, variation of the inner diameter of the roll of tape can be absorbed, and the roll of tape can be easily attached to the base rod with one single action, and workability of attaching operation of roll of tape can be improved.

These and other objects and features of the present invention will become clearer from the following description of the preferred embodiments given with reference to the attached drawings, wherein:
Fig. 1 is a partial sectional view showing a tape holding device according to an embodiment of the present invention;
Fig. 2 is a partial sectional view showing the tape holding device of Fig. 1 with a roll of tape clamped;
Fig. 3 is a partial sectional view showing the tape holding device of Fig. 1 with the roll of tape released from clamped state; and

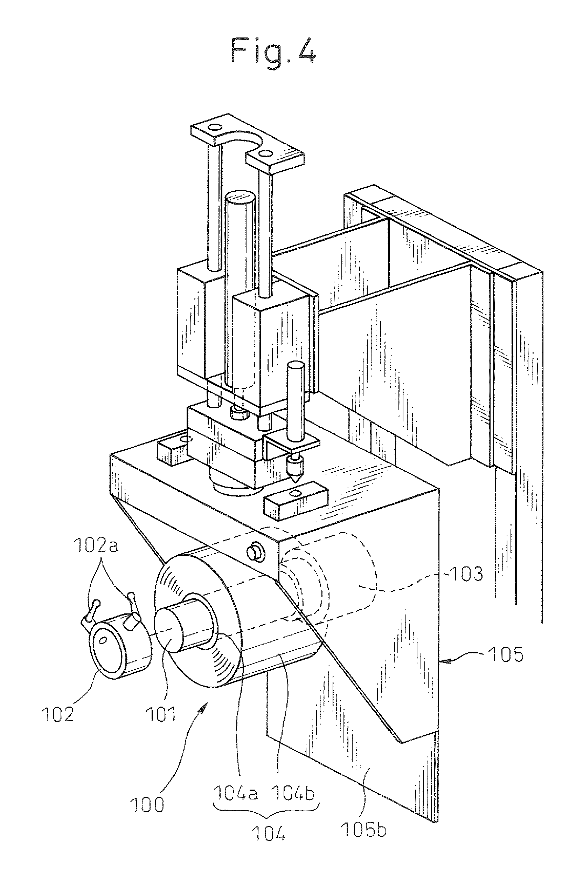

Fig. 4 is a perspective view showing an example of a tape holding device according to a prior art.

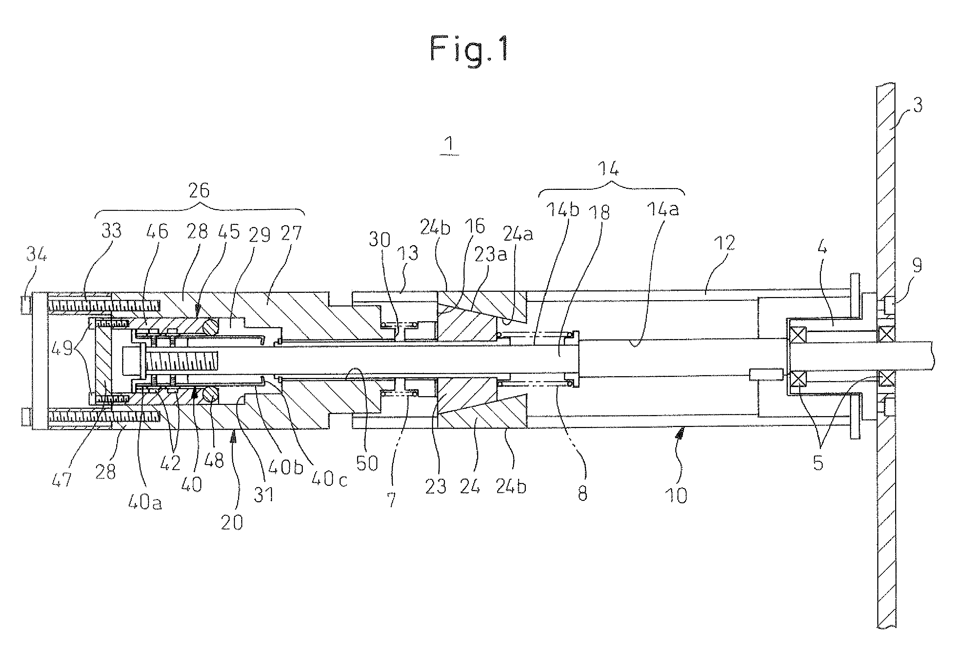

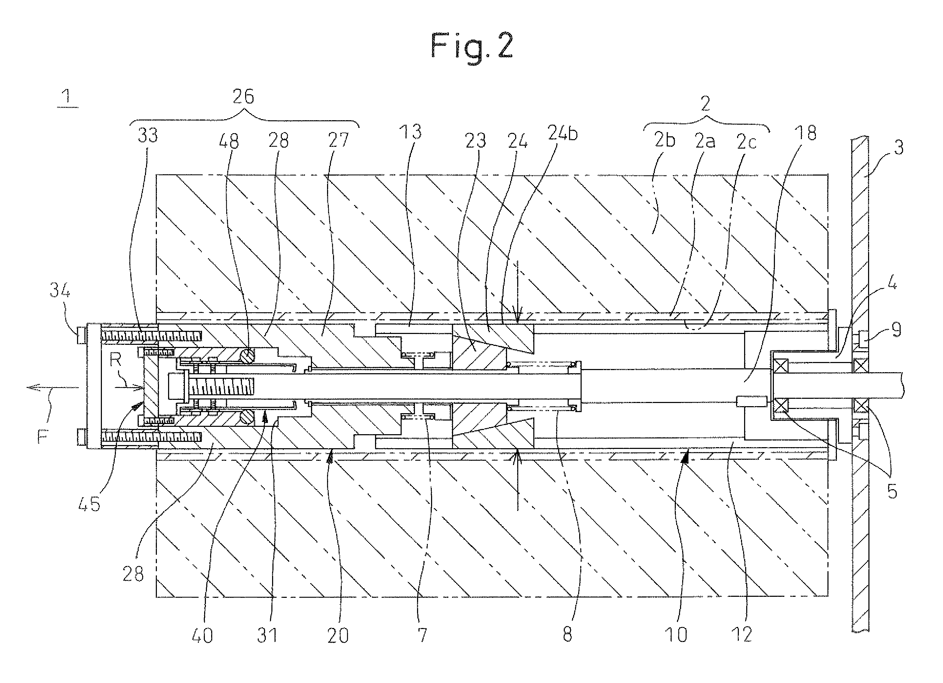

Specific examples of the present invention will be described below with reference to appended drawings showing embodiments thereof. Fig. 1 is a sectional view showing a tape holding device according to an embodiment of the present invention. The tape holding device 1 of this embodiment has a base rod (base rod member) 10 projecting horizontally from a generally vertical wall portion 3 such as a frame in cantilever state for holding a roll of tape 2 fitted from outside (Fig. 2), an unshown drive unit for rotating the base rod 10 about its axis, and a clamping rod (clamping rod member) 20 for clamping the roll of tape 2 by exerting internal pressure thereto. As shown in Fig. 2, the roll of tape 2 used has a protective tape 2b wound around a cylindrical core member 2a in a roll.

The base rod 10 is composed of a cylindrical rod body 12 having a through-hole 14 at the center of an axis and a long rod shaft (shaft) 18 pressed into the through-hole 14 to be integrated to the rod body 12 in one unit. The rear end side (basal end side or first mount end) of the rod shaft 18 is supported on a bearing 5 with the end connected to a driving source of the drive unit to be rotated thereby. Front end side (distal end side or second free end) of the rod shaft 18 projects from the front end face of the rod body 12 to be inserted into a through-hole 29 of the clamping rod 20 connected to the front end of the rod body 12. The base rod 10 and the clamping rod 20 are coaxially connected to each other via the rod shaft 18.

For the purpose of this specification, the concepts of "front" and "rear" are defined as follows. The term "front" refers to the distal end side (free end side) of the tape holding device 1 supported in cantilever state by the wall portion 3. The term "rear" refers to the basal end side of the tape holding device 1.

The rod body 12 has sufficient length for holding the roll of tape 2 fitted from outside so as to disengage, and has a through-hole 14 for the rod shaft 18 to be inserted in the center. The basal end of the rod body 12 is rotatably supported to the wall portion 3 via a boss 4 that is tightly fastened to the wall portion 3 with a bolt 9. The through-hole 14 is formed in a stepped shape corresponding to the size of the rod shaft 18 with small diameter in the rear end side and large diameter in the front end side. The small sized portion 14a in the rear end side is the portion for the rod shaft 18 to be pressed therein. By pressing the rod shaft 18 into the rod body 12, the two components are integrated in one unit so as to be rotated together by the driving source. The large sized portion 14b in the front end side that follows the small sized portion 14a in the rear end side is formed in a size sufficient to accommodate two front and rear coil springs (resilient member) 7, 8 disposed around the rod shaft 18.

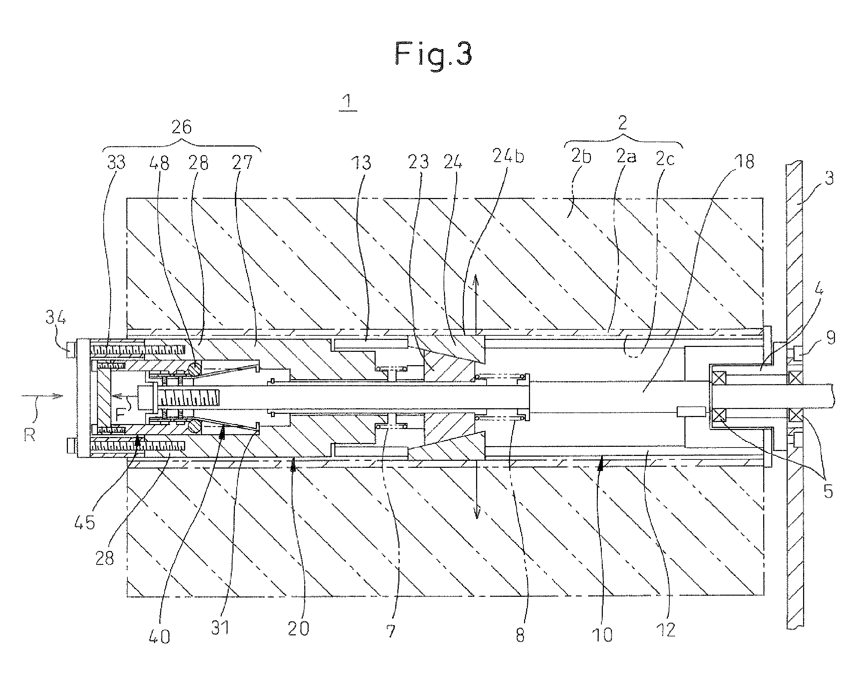

A cavity 16 is formed at position closer to the front end than the longitudinal midpoint of the rod body 12 and corresponding to the axial midpoint of the roll of tape 2 for accommodating a plurality of clamp dowels (clamp elements) 24 provided in circumferential direction of the rod body 12 so as to be movable in radial outward direction of the rod body 12. The cavity 16 is formed in a shape corresponding to the clamp dowels 24 in communication with the through-hole 14. The clamp dowels 24 are received in the cavity 16 and elastically supported by the front and rear coil springs 7, 8 at both axial sides of the clamp dowels 24. The clamp dowels 24 are received in such a manner that they can project from and retreat into the outer circumferential surface 13 of the rod body 12. As shown in Fig. 3, the outer circumferential portion of the dowels 24 is adapted to project in radial outward direction from the outer circumferential surface 13 of the rod body 12 to thereby exert pressure on the internal surface 2c of the roll of tape 2.

The drive unit has a motor as a driving source, a speed reduction gear for reducing the rotating speed of the motor to increase output torque, and a transmission mechanism for transmitting the diving force of the motor to the rod shaft 18. Various mechanisms such as a gear transmission mechanism, a belt transmission mechanism, etc. can be employed for the transmission mechanism.

The clamping rod 20 connected to the front end of the base rod 10 has the clamp dowels 24 received in the cavity 16 of the base rod 10, and a dowel pressing member (pressing unit) 26 for pushing the clamp dowels 24 in radial outward direction via the coil spring 7.

The dowel pressing member 26 includes a body 27 mounted to the front end of the base rod 10 and having a pair of arms 28, 28 arranged in opposition to each other, a pressing piece 23 disposed at inside of the clamp dowels 24 in sliding engagement with the clamp dowels 24, a coil spring (elastic member) 7 arranged between the body 27 and the pressing piece 23 and allowing the pressing piece 23 to move relative to the body 27 under elastic deformation of the coil spring 7, and U-shaped grasping member 33 fastened and fixed to the front end of the body 27.

The outer circumferential surface of the body 27 is formed in a circular arc such that the maximum outer diameter has smaller dimension than the inner diameter of the roll of tape 2 and the outer diameter of the rod body 12. At the axial center of the body 27, a through-hole 29 in which front end side of the rod shaft 18 is inserted is formed in communication with the through-hole 14 of the rod body 12.

The pressing piece 23 and the clamp dowel 24 are in sliding contact with each other at the tapered surfaces 23a, 24a so as to move the clamp dowel 24 in the direction perpendicular to the direction of the movement of the pressing piece 23.

Thus, by the wedge action of the pressing piece 23, a force that pushes the dowel pressing member 26 in axially rearward direction R of the rod shaft 18 is converted via the pressing piece 23 to a force that pushes the clamp dowel 24 in radial outward direction of the rod shaft 18, whereby the clamp dowel 24 is moved in the direction perpendicular to the moving direction of the pressing piece 23 so that the outer circumferential portion of the clamp dowel 24 in the cavity 16 projects from the outer circumferential surface 13 of the rod body 12. The pressing piece 23 can exert a large force, even with a small force of the pressing piece 23, due to its wedge action, so as to abut the clamp dowel 24 against the inner surface 2c of the roll of tape 2 and to fix the roll of tape 2 reliably.

An unshown engaging groove is formed on one of the tapered surface 23a, 24a of the pressing piece 23 and the clamp dowel 24, and an unshown protrusion that engages with the engaging groove is formed on the other tapered surface, and the two surfaces come into sliding contact with each other with the protrusion engaged into the engaging groove. By the engagement of the engaging groove with the protrusion, the clamping rod 20 is rotated together with the base rod 10.

A pair of arms 28, 28 provided on the front side portion of the body 27 are separated from each other in order to provide a pair of locking pieces (locking element) 40, 40 to be described later and a slider (releasing element) 45 between a pair of arms 28, 28. At the basal inner surface of a pair of arms 28, 28, there is formed an engaging step 31 capable of being engaged with the distal end of a pair of locking pieces 40, 40 as locking elements.

The rear side portion of the body 27 is formed in a size such that it can be inserted into the front end opening of the through-hole 14 of the rod body 12. The rear end face of the body 27 abuts against the end of the coil spring 7, so that the pressing force of the dowel pressing member 26 is transmitted via the coil spring 7 to the pressing piece 23.

The grasping member 33 is a member for an operator to grasp the dowel pressing member 26 for operation, and is fixed to the body 27 using fastening means such as a bolt 34. An operator needs only to grasp the grasping member 33 and push or pull the grasping member 33 in order to move the clamp dowel 24 in radial direction of the base rod 10.

As shown in Fig. 3, by grasping the grasping member 33 and moving the dowel pressing member 26 in rearward direction R, the pressing piece 23 is moved via the coil spring 7 on the front side in rearward direction R, and the clamp dowel 24 pushed by the pressing piece 23 is moved in radial outward direction, so that the clamp dowel 24 exerts on internal pressure on to the inner surface 2c of the roll of tape 2 and the roll of tape 2 is thereby fixed to the base rod 10. As the coil spring 7 on the front side always exerts biasing force to the pressing piece 23 in rearward direction, contact between the outer surface 24b of the clamp dowel 24 and the inner surface 2c of the roll of tape 2 is maintained. The coil spring 7 regulates the force applied to the inner surface 2c of the roll of tape 2 by the clamp dowel 24 with its own resilience so that the clamp dowel 24 pushes the inner surface 2c of the roll of tape 2 with a constant force. The coil spring 8 that elastically supports the pressing piece 23 on the rear side and biases the pressing piece 23 in forward direction F, is softer than the coil spring 7 (is set to have a smaller spring constant).

As shown in Fig. 2, when the grasping member 33 is pulled in forward direction, the pressing piece 23 is moved in forward direction F and the clamp dowel 24 is moved in radial inward direction so that the outer surface 24b of the clamp dowel 24 is separated from the inner surface 2c of the roll of tape 2 and the roll of tape 2 becomes ready to be removed from the base rod 10.

As has been described above, the tape holding device 1 according to the present embodiment has the clamp dowel 24, movable in the radial outward direction of the base rod 10, and a clamping rod 20 that has the dowel pressing member 26 for pushing the clamp dowel 24 in radial outward direction of the base rod 10, so that the force that pushes the dowel pressing member 26 toward the basal end side of the base rod 10 is converted to the force that pushes the clamp dowel 24 in the radial outward direction and can move the clamp dowel 24 in the radial outward direction of the base rod 10, whereby the clamp dowel 24 exerts pressure on to the inner surface 2c of the roll of tape 2 and the roll of tape 2 can be easily attached to the base rod 10.

Further, the tape holding device 1 according to the present invention has a pair of locking pieces (locking elements) 40, 40 for stopping the return of the dowel pressing member 26 and a slider 45 (releasing element) for unlocking. As shown in Fig. 1, a pair of locking pieces 40, 40 are provided on the front end side of the rod shaft 18. The locking piece 40 is punched from a resilient metal plate by a press and is formed into a curved shape. A pair of locking pieces 40, 40 are disposed in opposition to each other with the rod shaft positioned inbetween, and one end 40a is fastened to the front end side of the rod shaft 18 with a screw 42, and the other end 40b extends from the end 40a on the basal end side of the rod shaft 18 so as to form a free end gradually curving outward. (In Fig. 1, a roller 48 rises up on the locking piece 40 so as to make it straight. The locking piece in curved state can be seen in Fig. 3.) The free end of each locking piece 40 is bent and formed into the shape of a hook that functions as an engaging end 40c to abut against the engaging step 31 of the dowel pressing member 26 (a pair of arms 28).

A pair of locking pieces 40, 40 function as locking elements when, as shown in Fig. 3, the slider 45 is pulled in forward direction F and the dowel pressing member 26 is pushed in rear direction R, that is, when the roller 48 of the slider 45 does not rise up on the locking piece 40 and the distal end of the locking piece 40 is not bent outward. Thus, the locking elements of the tape holding device 1 are adapted to function when the roll of tape 2 is fixed to the base rod 10.

The releasing element is a slider 45 which reciprocates in the direction of the rod shaft 18 along the inner surface of a pair of arms 28, 28 of the dowel pressing member 26. The slider 45 is composed of a sliding contact member 46 that moves along the inner surface of a pair of arms 28, 28, a grasping member 47 fastened and fixed to the distal end of the sliding contact member 46 with a screw 49, and a roller 48 that rises up on a pair of locking pieces 40, 40 on the rear end side of the sliding contact member 46. The roller 48 is rotatably provided with a portion projecting inwardly from the inner surface of the sliding contact member 46. This slider 45 is pushed rearward, as shown in Figs. 1 and 2, to thereby bend the pair of locking pieces 40, 40 such that a pair of locking pieces is disengaged from the engaging step 31.

The slider 45 acts as follows. As shown in Fig. 2, with the dowel pressing member 26 pushed in rearward direction R, when an operator grasps the grasping member 47 and pushes the slider 45 in rearward direction R, the roller 48 rolls with the sliding contact member 46 in sliding contact with the inner surface of a pair of arms 28, 28. When the slider 45 is pushed further in rearward direction R, the roller 48 rises up on the locking piece 40 against the spring force exerted due to the locking piece 40 bent outward. The locking piece 40 is then bent inward and the engaging end 40c of the locking piece 40 slips away from the engaging step 31 of the inner surface of a pair of arms 28, 28 and is disengaged. Thus, the clamping rod 20 (dowel pressing member 26) becomes ready to move in forward direction F, that is, in clamp releasing direction, and the roll of tape 2 becomes ready to be removed from the base rod 10.

Next, in order to actuate a pair of locking pieces 40, 40 so as to lock the clamping rod 20 (dowel pressing member), with the dowel pressing member 26 pushed in rearward direction R, as shown in Fig. 3, the slider 45 needs only to be pulled in forward direction F. Then, a pair of locking pieces 40, 40 can be enabled to function again. Thus, when the slider 45 is pulled in the forward direction F, the roller 48 that has risen up on the locking piece 40 rolls down and the locking piece 40 is elastically restored to its original shape by its own spring force. By the engagement of the engaging end 40c of the locking piece 40 curved outward with the engaging step 31 of the inner surface of a pair of arms 28, 28, the roll of tape 2 is fixed to the base rod 10.

Thus, tape holding device 1 according to the present invention has a pair of locking pieces 40, 40 as locking elements, and by the engagement of the distal end of the locking piece 40 with the engaging step 31 formed on the inner surface of a pair of arms 28, 28 of the dowel pressing member 26, return of the dowel pressing member 26 can be prevented. Further, the tape holding device 1 has a slider 45 as releasing element, so that the engagement of the engaging step 31 with the locking piece 40 can be thereby cancelled, and the roll of tape 2 can be easily removed from the base rod 10.

The present invention is by no means limited to the above-described embodiment, but can be implemented in various modifications without departing from the scope of the invention. For example, although the tape holding device 1 of the present embodiment has a drive unit, the construction without a drive unit is also possible. The locking pieces 40 and the slider 45 may also be suitably modified in design. Although the pressing piece 23 is biased by the front side coil spring 7 in rearward direction R, this coil spring 7 may be omitted and the end face of the dowel pressing member 26 may directly abut against the end face of the pressing piece 23.

## Claims

1. A tape holding device (1) for holding, on a wall, a roll of tape having a cylindrical inner surface, comprising:
a base rod member (10) capable of being supported on the wall in a cantilever state, said base rod member including a first mount end capable of being rotatably mounted to the wall, a second free end opposite to said first end, and an outer surface between said first end and said second end; and
a clamping rod member (20) connected coaxially to said second end of said base rod member (10);
said clamping rod member (20) comprising:
a clamp element (24) provided movably in a radial direction of said base rod member (10) between an initial position where said clamp element does not project from said outer surface of said base rod member and a clamp position where said clamp element projects from said outer surface, said clamp element being capable of abutting the inner surface of the roll of tape at said clamp position to apply a pressure to the inner surface; and
a pressing unit (26) provided movably in an axial direction of said base rod member (10) between a non-operative position where said pressing unit does not press said clamp element and an operative position where said pressing unit presses said clamp element to move said clamp element from said initial position to said clamp position and to make said clamp element generate said pressure.

2. A tape holding device as claimed in claim 1, wherein said clamp element (24) is provided with a tapered inner surface, and said pressing unit (26) is provided with a tapered outer surface arranged in sliding engagement with said tapered inner surface of said clamp element, an axial movement of said pressing unit being converted to a radial movement of said clamp element through said sliding engagement between said tapered outer surface and said tapered inner surface.

3. A tape holding device as claimed in claim 1 or claim 2, wherein said base rod member (10) and said clamping rod member (20) are provided respectively with through-holes (14,29) along center axes thereof; and wherein said base rod member (10) comprises a shaft inserted into said through-holes and defining said first end and said second end of said base rod member, and a locking element (40) provided on said shaft and arranged in a through-hole of said clamping rod member, said locking element being capable of engaging with said pressing unit when said pressing unit is located at said operative position and retaining said pressing unit at said operative position.

4. A tape holding device as claimed in claim 3, wherein said clamping rod member (20) further comprises a releasing element (45) for releasing a locking function of said locking element (40).

5. A tape holding device as claimed in claim 4, wherein said locking element (40) comprises a bendable locking piece provided with a free end extending outward from said shaft to engage with said pressing unit located at said operative position; and wherein said releasing element (45) comprises a slider provided movably along said shaft in sliding contact with said locking piece, said slider capable of bending said locking piece due to a movement of said slider along said shaft to shift said free end inward and to release said locking function.

6. A tape holding device as claimed in any of the preceding claims, wherein said pressing unit (26) includes a body (27) mounted to said second end of said base rod member (10), a pressing piece (23) disposed at a location radial inside of said clamp element (24) in sliding engagement with said clamp element, and an elastic member (7) arranged between said body and said pressing piece and allowing said pressing piece to move relative to said body under elastic deformation of said elastic member.
